Europäisches Patentamt

European Patent Office

Office européen des brevets

(11) Publication number: **0 420 405 A2**

# EUROPEAN PATENT APPLICATION

(21) Application number: 90308861.5

(22) Date of filing: 10.08.90

(51) Int. Cl.5: **H01L 23/522**

The title of the invention has been amended (Guidelines for Examination in the EPO, A-III, 7.3).

(30) Priority: 31.08.89 US 401311

(43) Date of publication of application:
03.04.91 Bulletin 91/14

(84) Designated Contracting States:
DE FR GB IT

(71) Applicant: DELCO ELECTRONICS CORPORATION
700 East Firmin Street
Kokomo Indiana 46902(US)

(72) Inventor: **Leisure, Ronald K.**
**4604 Orleans Drive**
**Kokomo, IN 46902(US)**
Inventor: **Reger, Ronald K.**
**105 Banbury Road**
**Noblesville, IN 46060(US)**
Inventor: **Larsen, Oya F.**
**1605 East Southway Boulevard**
**Kokomo IN 46902(US)**

(74) Representative: **Haines, Arthur Donald et al**
**Patent Section Vauxhall Motors Limited 1st**
**Floor Gideon House 26 Chapel Street**
**Luton, Bedfordshire LU1 2SE(GB)**

(54) Integrated circuit comprising interconnections.

(57) A multilevel electrically conductive interconnect (12,20) is provided for an integrated circuit wherein an intermediate dual dielectric layer (18) is formed between the non-contacting portions of the conductors forming the conductive interconnect. The dual dielectric layer consists of a first dielectric layer (14) and a second dielectric layer (16), the latter, being formed from a polyimide material. The dual dielectric layer provides a significant improvement in defect density and a substantially planarized surface (26) for the deposition of the top conductor (20), thereby improving the reliability and integrity of the electrical interconnection and of the integrated circuit.

FIG. 1

EP 0 420 405 A2

## INTEGRATED CIRCUIT

The present invention relates to an integrated circuit having multilevel conductive interconnects and to a method of forming such an integrated circuit.

The embodiment described relates to an integrated circuit having multilevel conductive interconnects and which comprises a dual dielectric intermediate layer between the different levels of conductive interconnect.

Technology is continually seeking to miniaturize the individual components within an integrated circuit while concurrently increasing the complexity of the circuitry. As a consequence of these demands, innovative methods for positioning and electrically interconnecting the various components which are located on an integrated circuit have been developed. One known solution includes forming multilevel interconnections wherein two or more conductors which are on different levels of the integrated circuit are electrically interconnected by means of a via, or through-hole, which has been filled or plated with electrically conductive material. The conductors are separated from one another elsewhere by an intermediate dielectric layer.

Currently, these multilevel conductive interconnects are formed using only a single layer of plasma enhanced deposited silicon nitride as the intermediate dielectric material. Although being adequate, this method does have shortcomings.

By this method, the dielectric layer is deposited onto a first conductive strip, which typically is not planar but has upstanding sides and a top surface. The dielectric layer will therefore take the shape of this first conductive strip so as to be curved at the corners between the sides and top surface of this conductive strip. Thus the second, overlaying conductor is deposited onto the dielectric layer, so as to follow the shape of the dielectric layer. However the second conductor adheres poorly around these corners, which results in high electrical resistance between the two conductors at these points, which is highly undesirable.

Another shortcoming associated with this method arises as a result of there being only one intermediate dielectric layer between the first and second metal conductors. If the dielectric layer has any defects, the defects may cause electrical shorting between the first and second metal conductors. Again, this is highly undesirable in an integrated circuit.

The present invention seeks to provide an improved integrated circuit.

According to an aspect of the present invention, there is provided a method of forming an integrated circuit comprising a multilevel conductive interconnection; the method comprising, providing an appropriate substrate; forming a first conductive layer on the substrate; forming a first dielectric layer over the first conductive layer such that the first dielectric layer covers all but a portion of the first conductive layer; forming a second dielectric layer over the first dielectric layer so as to form a dual dielectric layer comprising the first dielectric layer and the second dielectric layer; and forming a second conductive layer on the dual dielectric layer such that the second conductive layer contacts the first conductive layer at said portion of the first conductive layer; thereby forming a multilevel conductive interconnect having a dual dielectric layer between the first and second conductive layers.

According to a second aspect of the present invention, there is provided an integrated circuit comprising a multilevel conductive interconnection, the circuit comprising an appropriate substrate; a first conductive layer provided on the substrate so as to form a first conductor; a first dielectric layer arranged so as to cover all but a portion of the top surface of the first conductive layer; a second dielectric layer provided on the first dielectric layer so as to form a dual dielectric layer having a substantially planar surface; and a second conductive layer provided on the substantially planar surface and contacting the first conductive layer at said portion of the top surface.

The dual dielectric layer can provide a substantially planar surface for the deposition of the top, or overlaying, second conductor. This can alleviate the typical shortcomings associated with poor step coverage of the second conductor. Further, the dual dielectric layer provides two intermediate layers which will, in practice have non-coincident defects, thereby decreasing the overall defect density of the intermediate dielectric layer, and resulting in a decreased probability of electrical shorting between the surrounding conductors.

An embodiment of the present invention is described below, by way of illustration only, with reference to the accompanying drawings, in which:

Figure 1 shows a cross-sectional view of a multilevel electrically conductive interconnect having an intermediate dual dielectric layer in accordance with an embodiment of the invention; and

Figure 2 shows an enlarged view of the intermediate dual dielectric layer of Figure 1.

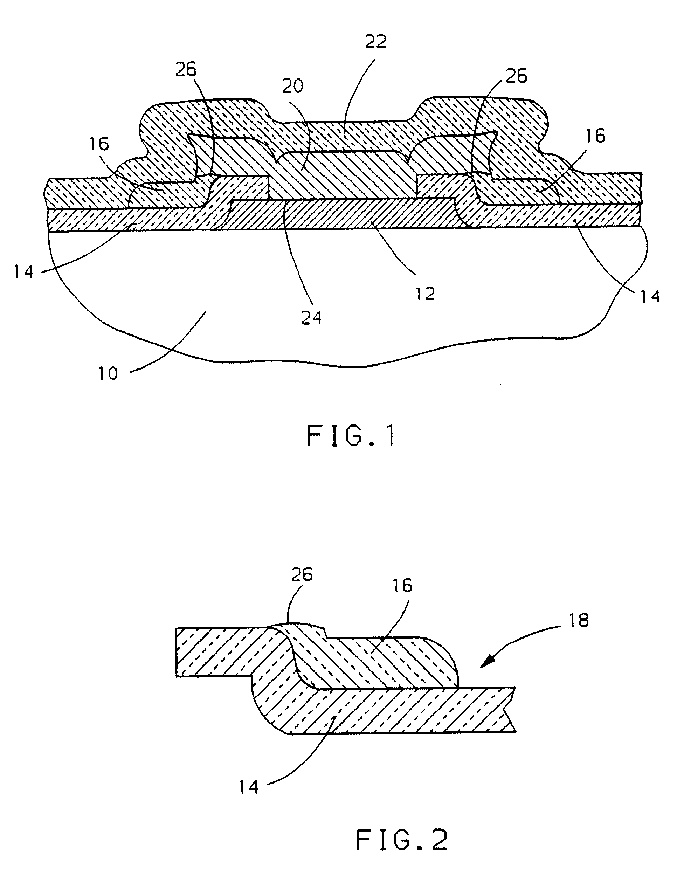

Referring to Figure 1, an integrated circuit is provided on an appropriate substrate 10, of single crystal silicon and comprises a first metal conductor 12 formed on the substrate 10. The conductor 12 is contacted, by means of a via or through-hole at its surface 24, by a second metal conductor 20, which has been formed on a separate level of the integrated circuit. The first and second conductors 12 and 20 are separated from one another, except at their contacted surface 24, by an intermediate dual dielectric layer 18, as better seen in Figure 2. The dual dielectric layer 18 consists of a first dielectric layer 14, formed from silicon oxide or silicon nitride, and a second dielectric layer 16, formed from a polyimide, such as the commercially available form known by the code 2703-D available from the Dupont Company. The combination of the polyimide layer 16 in the dual dielectric layer 18 decreases the overall pinhole defect density of the intermediate layer, thereby significantly reducing the probability of electrical shorting between the surrounding metal conductors 12 and 20, and improving the reliability of the integrated circuit. In addition, the dual dielectric layer 18 provides a substantially planar surface 26 upon which the second conductive layer 20 is deposited, thereby alleviating the problem of high electrical resistance due to the poor step coverage over the conventional single dielectric layer.

A third dielectric layer 22, of silicon oxide or silicon nitride, is blanket-deposited over the entire multilevel interconnect to form a primary seal on the polyimide layer 16 to prevent water absorption or other damage.

The first metal conductor 12 may be formed from any conventional conductive materials, and in this embodiment is a metal compound containing approximately 98% aluminium, 1% silicon and 1% copper, which is deposited onto the substrate 10 by a conventional deposition or printing technique. It has a thickness of approximately 1.5 to 1.8 micrometres, although this may vary depending on the intended application of the integrated circuit and size of the other components.

A first layer of dielectric material 14 is deposited and patterned on the first metal conductor 12 by conventional plasma assisted chemical vapour deposition of silicon oxide or silicon nitride, depending on the particular application. Silicon oxide is preferred in some applications because of its electrical characteristics, however the silicon nitride is preferred in other applications which do not require the electrical characteristics as it has better physical properties. This first dielectric layer 14 has a thickness of approximately 1.1 micrometres, and is preferably in the range of about 0.8 to about 1.2 micrometres. However, the thickness of this layer may vary considerably without significant detrimental effects.

The first dielectric layer 14 is patterned so as to expose the top surface 24 of the first conductor 12 for contact with the subsequently formed second conductor layer 20 to form a multilevel interconnect.

As is evident from Figure 1, the shape of the first dielectric layer 14 is dependent on the shape of the first conductor 12, such that it is stepped where it meets the edges of the first conductor 12. Using prior art techniques, this would have presented a serious shortcoming since the subsequently formed second metal conductor layer 20 would be deposited onto the curved upper surface of the dielectric layer 14. Typically, the metal coverage of the second conductor 20 at these parts of the dielectric layer 14 would be extremely poor and result in increased electrical resistance of the conductor.

To prevent this problem occurring, a second dielectric layer 16 is formed on the first dielectric layer 14 to form the dual dielectric structure 18. The material from which the second dielectric layer 16 is made, in this embodiment, is photosensitive and responds similarly to photoresist when exposed to light, such that patterning of the polyimide does not require any additional photoresist deposition steps.

The second dielectric layer 16 forms a substantially planar surface 26 in that region where the subsequently formed second conductive layer 20 will be deposited. This results in improved deposition and coverage of the second conductive layer 20, and alleviates the shortcomings associated with the prior art methods. In addition, the polyimide layer 16 decreases the overall pinhole or other defect density of the dielectric layer, thereby significantly increasing the reliability of the circuit.

The second dielectric layer 16 is formed by the following steps. The top surface of the first dielectric layer 14 is first cleaned, by means of exposure to an oxygen plasma for approximately 15 minutes. Polyimide is then spun onto the wafer using conventional means. The wafer is then soft-baked for 60 seconds on a hot plate held at 90°C to drive off any solvents, which is followed by 45 minutes of convection bake at 55°C. The wafer is then photolithographically patterned so as to be disposed upon the stepped regions of the first dielectric layer 14 to provide a substantially planarized surface 26 in that region. This is accomplished by exposing the wafer to a 9-11mW/cm$^2$ intensity lamp to polymerize the polyimide layer. The wafer is then developed by rinsing it in a solution consisting of 1:1 4-Butyrolactone:Xylene for approximately 25 seconds to remove the unpolymerized regions of the polyimide layer. The development process causes the polyimide layer to decrease in thickness by about 28 per cent.

For optimum results the duration between the initial cleaning to development steps should not exceed about four hours.

The photolithography stage is followed by a polyimide curing stage which comprises a first curing stage at a temperature of about 300°C for twenty minutes, followed by a second stage at a temperature of approximately 440°C for about 20 minutes. The thickness of the polyimide layer shrinks by approximately another 45 percent during curing.

After curing, a de-scumming step is carried out to remove the polyimide residue which has back-deposited in the conduits of the furnace tube. This consists of a short oxygen stripping step, which should not remove more than about 150 nanometres from the top surface of the polyimide layer. The final preferred thickness for the dry polyimide layer is approximately 1.6 to 1.8 micrometres, and preferably 1.7 micrometres.

Prior to deposition of the second conductive layer 20, the wafers are convection-baked at approximately 200°C for about 30 minutes to dry out the polyimide layer so as to prepare its surface for good metal adhesion during deposition of the second conductive layer 20.

The second conductive layer 20 is then formed by sputtering an appropriate metal, which may be the composition used to form the first metal conductor 12, everywhere on the surface of the wafer. The sputtering cycle consists of a first RF etch to clean the surface, followed by a 350°C preheat cycle, which is subsequently followed by the actual deposition step at a temperature of about 300°C using, for example a Varian 3190 type machine for the chemical vapour deposition or sputtering.

An appropriate photoresist is then used to pattern the second conductive layer 20. The photoresist is subsequently stripped by a wet chemical which is specifically selected for preserving the polyimide layer 16 integrity and preventing any damage to the other layers. The preferred wet chemical etch is commercially available as KTI DC-3 Stripper from KTI Chemical, which comprises 1-methyl-2-pyrrolidinone, 2-"2-butoxyethoxy" ethanol and monoethanolamine.

The final thickness of this second conductive layer 20 ranges between about 2.2 to about 2.9 micrometres.

After this wet photoresist stripping step, another de-scumming step is carried and to ensure the dielectric quality of the top surface of the polyimide layer. The de-scumming step is similar to the previous de-scumming step described above.

Finally, a passivation layer 22, of silicon nitride or the like, is blanket-deposited over the other layers, particularly to passivate the various materials and seal the exposed second dielectric layer 16 so as to prevent it from absorbing water and from being damaged in other ways. This passivation layer 22 should have a thickness of about 1.3 to about 1.7 micrometres, depending upon the thickness of the other layers.

The dual dielectric layer 18 provides a substantially planarized surface 26 for the deposition of the top conductor 20 thereby ensuring good coverage and electrical integrity, while also significantly decreasing the overall defect density of the intermediate dual dielectric layer 18 so as to decrease substantially the probability of electrical shorting between the surrounding metal conductors 12 and 20.

As a result of the above construction, the first conductive layer 14 is not limited in thickness by reason of the step coverage requirements of the second conductive layer 16, and a defect in one of the dielectric layers is not likely to cause shorting. For there to be shorting, there would have to be coincident defects in the first and second dielectric layers.

## Claims

1. A method of forming an integrated circuit comprising a multilevel conductive interconnection; the method comprising providing an appropriate substrate (10); forming a first conductive layer (12) on the substrate; forming a first dielectric layer (14) over the first conductive layer such that the first dielectric layer covers all but a portion of the first conductive layer; forming a second dielectric layer (16) over the first dielectric layer so as to form a dual dielectric layer (18) comprising the first dielectric layer and the second dielectric layer; and forming a second conductive layer (20) on the dual dielectric layer such that the second conductive layer contacts the first conductive layer at said portion of the first conductive layer; thereby forming a multilevel conductive interconnect having a dual dielectric layer between the first and second conductive layers.

2. A method accord.ing to claim 1, comprising depositing a third dielectric layer (22) over the first and second conductive layers and the first and second dielectric layers so as substantially to envelop the second dielectric layer.

3. A method according to claim 1 or 2, wherein the substrate is of silicon, the first and second conductive layers one of metal, the first dielectric layer is of silicon oxide or silicon nitride and the second dielectric layer is made of a polyimide dielectric material.

4. An integrated circuit comprising a multilevel conductive interconnection, the circuit comprising an appropriate substrate (10); a first conductive layer (12) provided on the substrate so as to form a first conductor; a first dielectric layer (14) arranged so as to cover all but a portion of the top surface of the first conductive layer; a second dielectric layer (16) provided on the first dielectric layer so as to form a dual dielectric layer (18) having a substantially planar surface (26); and a second conductive layer (20) provided on the substantially planar surface and contacting the first conductive layer at said portion of the top surface.

5. An integrated circuit according to claim 4, comprising a third dielectric layer (22) provided on the first and second conductive layers and the first and second dielectric layers so as substantially to envelop the second metal conductive layer.

6. An integrated circuit according to claim 4 or 5, wherein the substrate is of silicon; the first and second conductive layers are of metal; the first dielectric layer is of silicon oxide or silicon nitride; and the second dielectric layer is made of a polyimide dielectric material.

FIG.1

FIG.2